# EUROPÄISCHE PATENTSCHRIFT

(11) **EP 1 129 523 B1**
(45) Veröffentlichungstag und Bekanntmachung des Hinweises auf die Patenterteilung: **14.08.2002**
(21) Anmeldenummer: 99963242.5
(22) Anmeldetag: 15.11.1999
(51) Int. Cl.: H03M 7/36

(54) **SCHALTUNGSANORDNUNG ZUR QUANTISIERUNG DIGITALER SIGNALE UND FILTERUNG DES QUANTISIERUNGSRAUSCHENS**
CIRCUIT CONFIGURATION FOR QUANTISATION OF DIGITAL SIGNALS AND FOR FILTERING QUANTISATION NOISE
CIRCUIT POUR LA QUANTIFICATION DE SIGNAUX NUMERIQUES ET POUR FILTRER LE BRUIT DE QUANTIFICATION

(30) Priorität: 20.11.1998 DE 19853673
(43) Veröffentlichungstag der Anmeldung: 05.09.2001
(73) Patentinhaber: Infineon Technologies AG, 81669 München (DE)
(72) Erfinder: HAUPTMANN, Jörg, A-9241 Wernberg (AT); PESSL, Peter, A-8160 Nöstl (AT); STRÄUSSNIGG, Dietmar, A-9500 Villach (AT)
(74) Vertreter: Reinhard - Skuhra - Weise & Partner
(86) Internationale Anmeldenummer: DE9903632
(87) Internationale Veröffentlichungsnummer: WO0031879

(56) Entgegenhaltungen:
- DE-C- 19 722 434
- US-A- 5 369 403

## Beschreibung

Die Erfindung betrifft eine Schaltungsanordnung zur Quantisierung digitaler Signale und Filterung des Quantisierungsrauschens nach dem Oberbegriff von Patentanspruch 1, wie aus der US-A-5,369,403 bekannt.

Überabtastende Digital-Analog-Umsetzer, die nach dem Sigma-Delta-Verfahren arbeiten, weisen ein Interpolationsfilter zur Abtastratenerhöhung, eine nachgeschaltete Schaltungsanordnung zur Quantisierung und Filterung des Quantisierungsrauschens (Noise-Shaping-Loop) und einen Digital-Analog-Umsetzer mit geringer Eingangswortbreite auf.

Aus US 5,369,403 ist ein Sigma-Delta-Digital-Analog-Umsetzer mit kleinem Quantisierungsfehler bekannt, der einen ersten und zweiten digitalen Regelkreis zur Quantisierung aufweist. Der zweite digitale Regelkreis verarbeitet den Quantisierungsfehler des ersten digitalen Regelkreis. Die quantisierten Ausgangssignale des ersten und zweiten digitalen Regelkreises werden jeweils von einem ersten bzw. zweiten Digital-Analog-Umsetzer in ein erstes bzw. zweites analoges Signal umgesetzt. Das zweite analoge Signal wird analog gefiltert und zu dem ersten analogen Signal zu einem analogen Signal, das nur einen kleinen Quantisierungsfehler aufweist, addiert. Nachteilig ist dabei die aufwendige analoge Filterung des zweiten Signals und die fehlerbehaftete analoge Addition, die die Linearität des umgesetzten analogen Signals einschränkt.

Aus der DE 19722434 C ist eine Schaltung mit mehreren digitalen Regelkreisen bekannt, wobei einem zweiten Regelkreis das Quantisierungsfehlersignal eines ersten Regelkreises als Eingangssignal zugeführt wird und zusätzlich ein digitaler Hochpassfilter am Ausgang des zweiten Regelkreises vorhanden ist. Das gefilterte Ausgangssignal des zweiten Regelkreises wird jedoch zu dem Eingangssignal der Schaltung und dem im ersten Regelkreis gefilterten Quantisierungsfehler addiert.

Das der Erfindung zugrundeliegende technische Problem besteht daher darin, eine Schaltungsanordnung zur Quantisierung digitaler Signale und Filterung des Quantisierungsrauschens anzugeben, die ausschließlich digitale Mittel aufweist und digitale Ausgangssignale mit geringem Quantisierungsrauschen erzeugt.

Dieses Problem wird von einer Schaltungsanordnung zur Quantisierung digitaler Signale und Filterung des Quantisierungsrauschens mit den Merkmalen von Patentanspruch 1 gelöst. Vorteilhafte Ausgestaltungen der Erfindung ergeben sich aus den jeweiligen Unteransprüchen.

Die Erfindung betrifft eine Schaltungsanordnung zur Quantisierung digitaler Signale und Filterung des Quantisierungsrauschens. Die Schaltungsanordnung weist eine Vielzahl von in Reihe geschalteten digitalen Regelkreisen mit Quantisierern auf. Einem ersten Regelkreis der Reihe werden die digitalen Signale, die eine erste Wortbreite von m-Bit aufweisen, zugeführt. Das Quantisierungsfehlersignal jedes Quantisierers wird im jeweiligen digitalen Regelkreis gefiltert und rückgekoppelt. Das Quantisierungsfehlersignal jedes Quantisierers wird einem nachgeschalteten digitalen Regelkreis zugeführt. Das quantisierte Ausgangssignal des ersten digitalen Regelkreises wird auf eine dritte Wortbreite von u-Bit, die kleiner als die erste Wortbreite ist, angepaßt. Die quantisierten Ausgangssignale der digitalen Regelkreise der Reihe werden außer dem quantisierten Ausgangssignal des ersten digitalen Regelkreises jeweils von einem digitalen Filter gefiltert und mit dem quantisierten Ausgangssignal des ersten digitalen Regelkreises der Reihe zur Auslöschung der Quantisierungsfehler in einem Addierer addiert, dessen Ausgangssignal eine zweite Wortbreite von n-Bit aufweist und das quantisierte Ausgangssignal der Schaltungsanordnung ist. Vorteilhafterweise wird mit digitalen Mitteln das durch den Quantisierungsfehler verursachte Quantisierungsrauschen verringert. Ein weiterer Vorteil ergibt sich aus der ausschließlichen Verwendung digitaler Mittel, die eine nur durch die Wortbreite der Rechenschaltungen begrenzte Genauigkeit ermöglichen. Weiterhin sind digitale Mittel insbesondere bei einer Integration der Schaltungsanordnung auf einem monolithischen Bauelement einfacher als analoge Mittel zu verwenden.

Durch die digitale Filterung des Ausgangssignals jedes digitalen Regelkreises außer dem ersten digitalen Regelkreis und die Summation der Ausgangssignale jedes digitalen Regelkreises wird der Quantisierungsfehler des jeweils vorgeschalteten digitalen Regelkreises ausgelöscht. Übrig bleibt der Quantisierungsfehler des letzten digitalen Regelkreises der Reihe, da diesem kein weiterer digitaler Regelkreis zur Auslöschung des Quantisierungsfehlers nachgeschaltet ist. Vorteilhaft ist dabei, daß auch Signale mit einer geringen Überabtastung des zugrundeliegenden Signals durch diese Schaltungsanordnung mit einem sehr geringen Quantisierungsfehler quantisiert werden können. In einem solchen Fall wird das durch einen Quantisierungsfehler erzeugte Rauschspektrum effizient gefiltert und trotz der aufgrund einer niedrigen Abtastfrequenz naheliegenden Nutzsignalspektren des abgetasteten Signals aus dem ursprünglichen Nutzsignalspektrum des abgetasteten Signals augelöscht.

In einer bevorzugten Ausführungsform weist jedes digitale Filter ein Hochpaßfilter auf. Vorteilhafterweise wird dadurch das Rauschspektrum, das durch den Quantisierungsfehler des letzten digitalen Regelkreises der Reihenschaltung verursacht wird, bei tiefen Frequenzen gedämpft und stört weniger die bei tiefen Frequenzen liegenden Spektralanteile eines Nutzsignals.

In einer besonders bevorzugten Ausführungsform weist jedes digitale Filter zwei in Reihe geschaltete Differenzierer erster Ordnung auf. Von Vorteil ist der einfache Aufbau jedes digitalen Filters mit digitalen Mitteln. Es werden lediglich zwei Subtrahierer und zwei Verzögerungsglieder zum Aufbau benötigt.

Die Quantisierer quantisieren in einer bevorzugten Ausführungsform ein Eingangssignal durch Abschneiden der niederwertigen Bits des Eingangssignals. Vorteilhafterweise erfordert die Methode des Abschneidens der niederwertigen Bits einen sehr geringen schaltungstechnischen Aufwand.

In einer alternativen bevorzugten Ausführungsform quantisieren die Quantisierer ein Eingangssignal durch Runden anstelle durch Abschneiden. Diese Methode ist zwar gegenüber dem Quantisieren durch Abschneiden schaltungstechnisch aufwendiger, liefert dafür aber genauere Ergebnisse.

Jeder digitale Regelkreis weist bevorzugt einen dem Quantisierer vorgeschalteten Begrenzer, eine Filterstruktur zur Filterung des Quantisierungsfehlersignals und einen Addierer, der ein Eingangssignal mit dem gefilterten Quantisierungsfehlersignal addiert, auf. Dabei verhindert der Begrenzer eine Überschreitung des durch die nachfolgenden Schaltungsstrukturen vorgegebenen Wertebereichs.

Besonders bevorzugt ist jeder digitale Regelkreis höchstens zweiter Ordnung, um Stabilitätsprobleme zu vermeiden. Höhere Ordnungen als die zweite Ordnungen benötigen Mittel zur Verbesserungen der Stabilität, wodurch der Schaltungsaufwand des digitalen Regelkreises steigt.

Weitere Vorteile, Merkmale und Anwendungsmöglichkeiten der Erfindung ergeben sich aus der nachfolgenden Beschreibung eines Ausführungsbeispiels in Verbindung mit der Zeichnung. In der Zeichnung zeigt
- Figur 1: ein erstes Ausführungsbeispiel der erfindungsgemäßen Schaltungsanordnung zur Quantisierung digitaler Signale und Filterung des Quantisierungsrauschens;
- Figur 2: ein zweites Ausführungsbeispiel der erfindungsgemäßen Schaltungsanordnung zur Quantisierung digitaler Signale und Filterung des Quantisierungsrauschens;
- Figur 3: ein drittes Ausführungsbeispiel der erfindungsgemäßen Schaltungsanordnung zur Quantisierung digitaler Signale und Filterung des Quantisierungsrauschens; und
- Figur 4: das Quantisierungsrauschspektrum eines Quantisierers ohne Noise-Shaping-Loop und einer Noise-Shaping-Loop erster und zweiter Ordnung.

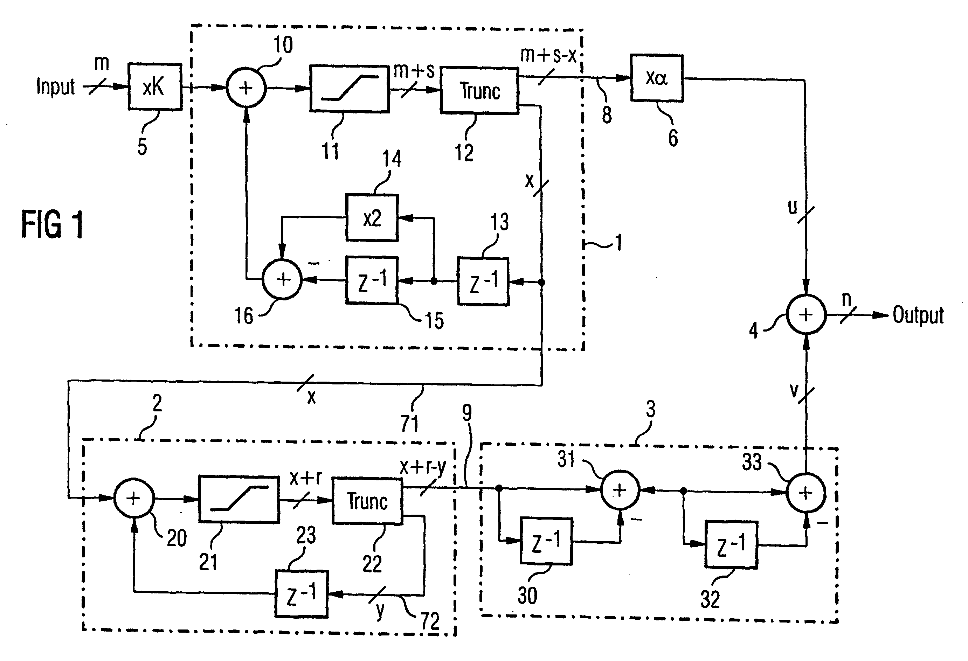

In Figur 1 wird ein digitales Eingangssignal Input mit einer ersten Wortbreite von m-Bit einem ersten Multiplizierer 5 zugeführt. Der erste Multiplizierer 5 multipliziert das Eingangssignal Input mit einem konstanten Faktor k, der kleiner als eins ist, und kann dazu beispielsweise als Schieberegister aufgebaut sein. Durch die Multiplikation mit dem konstanten Faktor k wird der Wertebereich des Eingangssignals Input verringert, um einen Überlauf in den nachfolgenden Schaltungen zu vermeiden. Das Ausgangssignal des ersten Multiplizierers 5 wird einem ersten digitalen Regelkreis 1 zugeführt.

Der erste digitale Regelkreis weist einen ersten Addierer 10 auf, der das dem ersten digitalen Regelkreis 1 zugeführte Signal mit einem rückgekoppelten Signal addiert. Der Ausgang des Addierers 10 ist mit einem ersten Begrenzer oder Sättiger 11 verbunden, der den Wertebereich eines zugeführten Signals auf eine Wortbreite von (m+s)-Bits anpaßt. Dem ersten Begrenzer oder Sättiger 11 ist wiederum ein erster Quantisierer 12 nachgeschaltet, der ein Eingangssignal in ein erstes quantisiertes Signal 8 mit den höherwertigen (m+s-x)-Bits und einem erstes Quantisierungsfehlersignal 71 mit den niederwertigen x-Bits des Eingangssignals auftrennt. Es kann jedoch auch durch Runden statt durch Abschneiden quantisiert werden. Das erste Quantisierungsfehlersignal 71 wird gefiltert und auf den ersten Addierer 10 rückgekoppelt. Der Rückkoppelpfad weist zur Filterung ein erstes Verzögerungsglied 13, ein nachgeschaltetes zweites Verzögerungsglied 15 und parallel einen zweiten Multiplizierer 14, der mit einem konstanten Faktor von 2 multipliziert und beispielsweise als Schieberegister ausgeführt sein kann, auf. Das Ausgangssignal des zweiten Verzögerungsgliedes 15 wird in einem Subtrahierer 16 von dem Ausgangssignal des zweiten Multiplizierers 14 subtrahiert.

Durch diese auch als Fehlerrückkoppelung bezeichnete Rückkoppelung des frequenzmäßig gewichteten Quantisierungsfehlers wird das in dem ersten quantisierten Signals 8 enthaltene Quantisierungsrauschen bei niedrigen Frequenzen unterdrückt und steigt zu höheren Frequenzen an. Deshalb spricht man auch von einer Noise-Shaping-Loop. Aus Stabilitätsgründen sollte die Ordnung des ersten digitalen Regelkreises nicht größer als zwei sein, was hier durch zwei Verzögerungsglieder im Rückkoppelpfad gewährleistet ist. Der erste digitale Regelkreis ist somit eine Noise-Shaping-Loop zweiter Ordnung.

Das erste quantisierte Signal 8 wird einem dritten Multiplizierer 6 zugeführt, der die Wortbreite des ersten quantisierten Signals 8 von (m+s-x)-Bit auf eine dritte Wortbreite von u-Bit, die kleiner als die erste Wortbreite von m-Bit ist, anpaßt. Dazu kann der dritte Multiplizierer 6 beispielsweise als einfaches Schieberegister ausgeführt sein.

Das erste Quantisierungsfehlersignal 71 wird einem zweiten Regelkreis 2 zugeführt.

Der zweite Regelkreis 2 ist als Noise-Shaping-Loop erster Ordnung aufgebaut und weist dazu einen zweiten Addierer 20 auf, der das erste Quantisierungsfehlersignal 71 als Eingangssignal mit einem zweiten gefilterten Quantisierungsfehlersignal 72, das eine Wortbreite von y-Bit aufweist, addiert. Das Ausgangssignal des zweiten Addierers 20 wird einem zweiten Begrenzer oder Sättiger 21 zur Anpassung der Wortbreite auf (x+r)-Bits und einem dem zweiten Begrenzer oder Sättiger 21 nachgeschalteten zweiten Quantisierer 22 zugeführt. Der zweite Quantisierer 22 trennt das zugeführte Signal in ein zweites quantisiertes Signal 9 mit den höherwertigen (x+r-y)-Bits und ein zweites Quantisierungsfehlersignal 72 mit den niederwertigen y-Bits des zugeführten Signals auf. Das zweite Quantisierungsfehlersignal 72 wird einem dritten Verzögerungsglied 23 zur Filterung zugeführt, dessen Ausgangssignal wiederum dem zweiten Addierer 20 zugeführt wird.

Das zweite quantisierte Signal 9, das nun eine Wortbreite von (x+r-y)-Bit aufweist, wird einem digitalen Filter 3 zugeführt. Der digitale Filter 3 weist einen ersten und eine zweiten in Reihe geschalteten Differenzierer erster Ordnung auf. Der erste und zweite Differenzierer weist ein viertes Verzögerungsglied 30 bzw. ein fünftes Verzögerungsglied 32 und einen zweiten Subtrahierer 31 bzw. einen dritten Subtrahierer 33 auf. Die Übertragungsfunktion des digitalen Filters 3 entspricht einer Hochpaß-Übertragungsfunktion.

Das Ausgangssignal des digitalen Filters 3 wird mit dem Ausgangssignal des dritten Multiplizierers 6 in einem zweiten Addierer 4 zu einem Ausgangssignal Output der Schaltungsanordnung mit einer zweiten Wortbreite von n-Bit, die kleiner als die erste Wortbreite von m-Bit ist, addiert.

Durch die Filterung in dem digitalen Filter 3 wird der in dem ersten digitalen Regelkreis 1 erzeugte Quantisierungsfehler ausgelöscht. Lediglich der Quantisierungsfehler des zweiten digitalen Regelkreises 2 bleibt übrig.

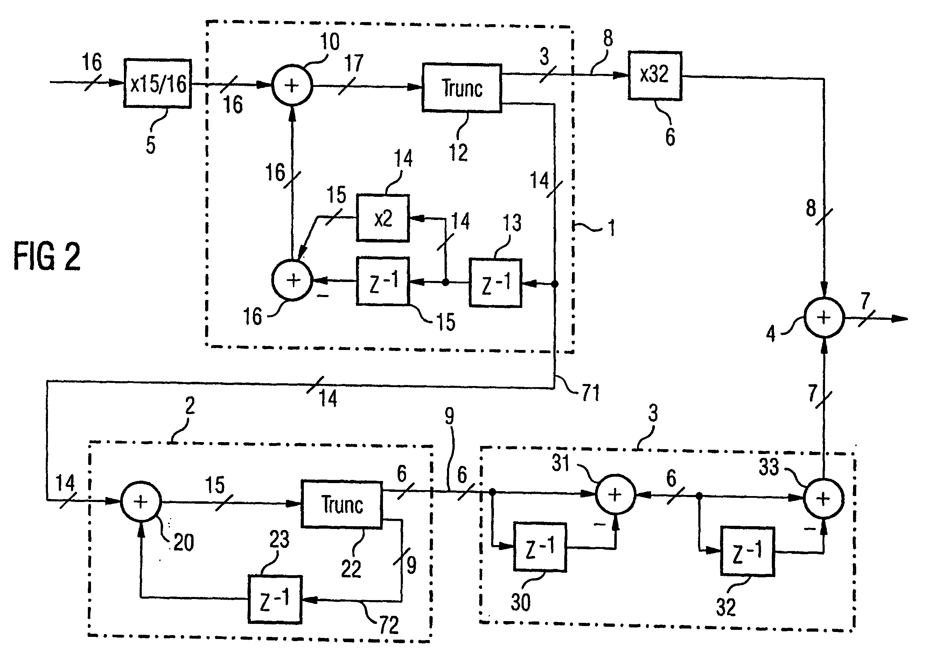

Figur 2 zeigt ein Ausführungsbeispiel der erfindungsgemäßen Schaltungsanordnung zur Quantisierung digitaler Signale und Filterung des Quantisierungsrauschens, in dem die Wortbreiten der einzelnen Signale eingetragen sind. Die Elemente in Figur 2 sind mit den gleichen Bezugszeichen der Elemente aus Figur 1 bezeichnet. Im Gegensatz zu der in Figur 1 dargestellten Schaltung fehlen der erste und zweite Begrenzer oder Sättigerr 11 bzw. 21, die weggelassen werden können, wenn der durch die einzelnen Elemente vorgegebene Wertebereich nicht überschritten wird.

Ferner wird ein Ubertragssignal des zweiten Subtrahierers 31 nicht benötigt, da gezeigt werden kann, daß der durch den zweiten Subtrahierer 31 vorgegebene Wertebereich nicht überschritten wird. Das gleiche gilt für den zweiten Addierer 4.

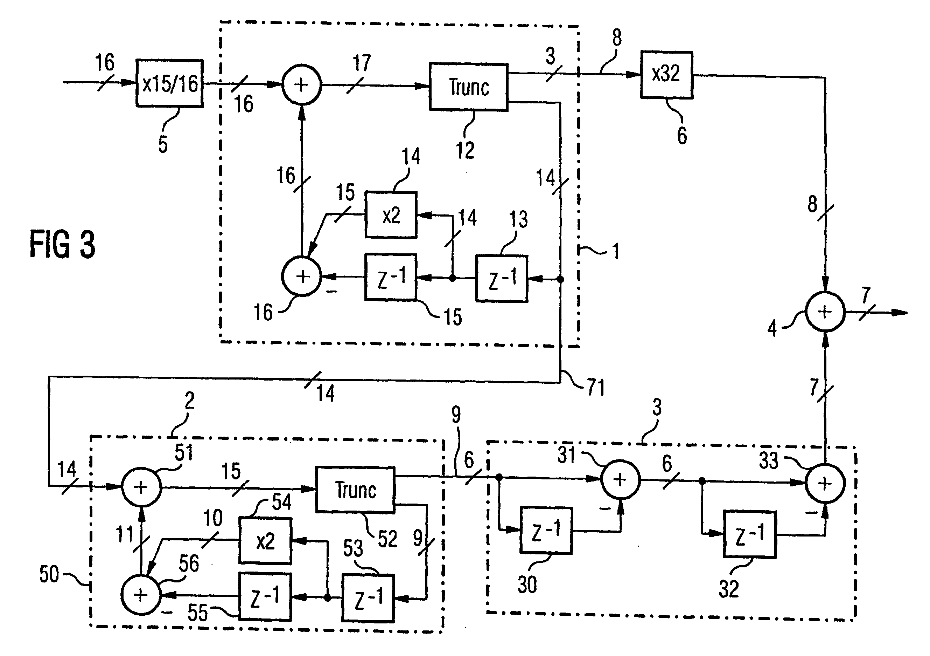

Figur 3 zeigt ein Ausführungsbeispiels der erfindungsgemäßen Schaltungsanordnung zur Quantisierung digitaler Signale und Filterung des Quantisierungsrauschens mit einem ersten digitalen Regelkreis 1, der der gleiche digitale Regelkreis wie in Figur 2 ist, und einem zweiten digitalen Regelkreis 50, der wie der erste digitale Regelkreis 1 aufgebaut ist. Damit sind zwei Noise-Shaping-Loops zweiter Ordnung in Reihe geschaltet und ergeben insgesamt eine Noise-Shaping-Loop vierter Ordnung.

Der zweite digitale Regelkreis 50 weist einen Addierer 51, einen dem Addierer 51 nachgeschalteten Quantisierer 52 und einen Rückkoppelpfad auf. Der Rückkoppelpfad weist wie der Rückkoppelpfad im ersten digitalen Regelkreis 1 ein erstes Verzögerungsglied 53, ein dem ersten Verzögerungsglied 53 nachgeschaltetes zweites Verzögerungsglied 55 und parallel dazu einen Multiplizierer 54 auf. Die Ausgangssignal des zweiten Verzögerungsgliedes 55 und des Multiplizierers 54 werden einem Subtrahierer 56 zugeführt, dessen Ausgangssignal dem Addierer 51 zur Addition mit dem Eingangssignal des zweiten digitalen Regelkreises zugeführt wird.

Der aufwendigere Aufbau des zweiten digitalen Regelkreises 50 (Im Vergleich zu dem Aufbau des zweiten digitalen Regelkreises 2 des ersten und zweiten Ausführungsbeispiels) ermöglicht eine niedrigere Abtastrate des zu quantisierende Signals bei einem Signal-Rausch-Verhältnis, das gleich dem Signal-Rausch-Verhältnis der Schaltungsanordnungen des ersten und zweiten Ausführungsbeispiels ist, des quantisierten Ausgangssignals.

Bei einem gewünschten Signal-Rausch-Verhältnis von 94 dB, einem 16 Bit Eingangssignal und einem 7 Bit Ausgangssignal der Schaltungsanordnung zur Quantisierung digitaler Signale und Filterung des Quantisierungsrauschens kann die Abtastrate des Eingangssignals von einer zwölffachen Überabtastung auf eine achtfache Überabtastung verringert werden.

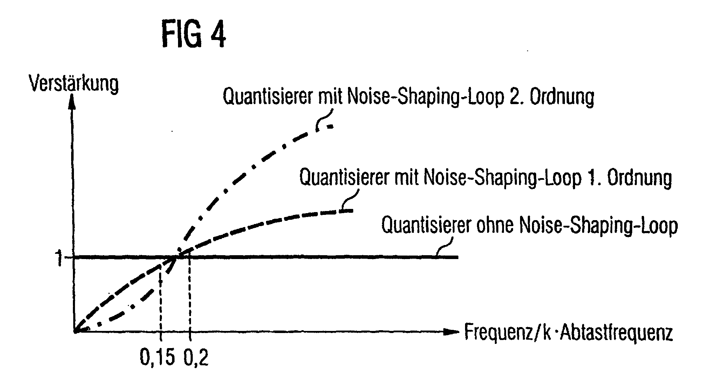

Figur 4 zeigt das Quantisierungsrauschspektrum eines Quantisierers ohne Noise-Shaping-Loop und einer Noise-Shaping-Loop erster und zweiter Ordnung. Daraus ist erkennbar, daß zwar durch Noise-Shaping die Rauschleistung insgesamt etwas erhöht wird, aber bei niedrigen Frequenzen die Rauschleistung gegenüber einem einfachen Quantisierer ohne Noise-Shaping niedriger ist. Ein einem Digital-Analog-Umsetzer, der das quantisierte Signal in ein analoges Signal umsetzt, nachgeschaltetes Tiefpaßfilter sollte daher eine steile Filterkennlinie aufweisen, um den höherfrequenten Rauschanteil des Quantisierungsrauschens zu dämpfen.

## Patentansprüche

1. Schaltungsanordung zur Quantisierung digitaler Signale und Filterung des Quantisierungsrauschens, wobei die Schaltungsanordnung eine Vielzahl von digitalen Regelkreisen (1, 2) mit jeweiligen Quantisierern (12, 22) aufweist und einem ersten Regelkreis (1) die digitalen Signale, die eine erste Wortbreite von m-Bit aufweisen, zugeführt werden, wobei das Quantisierungsfehlersignal (71, 72) jedes Quantisierers (12, 22) im jeweiligen digitalen Regelkreis (1, 2) rückgekoppelt und im Rückkopplungspfad gefiltert wird, und wobei das Quantisierungsfehlersignal (71) des Quantisierers (12) des ersten digitalen Regelkreises (1) einem zweiten digitalen Regelkreis (2) zugeführt wird,
**dadurch gekennzeichnet, dass**
- das quantisierte Ausgangssignal (8) des ersten digitalen Regelkreises (1) auf eine dritte Wortbreite von u-Bit, die kleiner als die erste Wortbreite ist, angepasst wird;
- die quantisierten Ausgangssignale (9) des zweiten digitalen Regelkreises (2) von einem dem zweiten digitalen Regelkreis (2) nachgeschalteten digitalen Filter (3) gefiltert werden und mit dem quantisierten Ausgangssignal (8) des ersten digitalen Regelkreises (1) zur Auslöschung der Quantisierungsfehler in einem Addierer (4) addiert werden, dessen Ausgangssignal eine zweite Wortbreite von m-Bit aufweist und das quantisierte Ausgangssignal der Schaltungsanordnung ist.

2. Schaltungsanordnung nach Anspruch 1,
**dadurch gekennzeichnet, daß**
jedes digitale Filter (3) ein Hochpaßfilter aufweist.

3. Schaltungsanordnung nach einem der vorhergehenden Ansprüche,
**dadurch gekennzeichnet, daß**
jedes digitale Filter (3) zwei in Reihe geschaltete Differenzierer erster Ordnung (30 - 33) aufweist.

4. Schaltungsanordnung nach einem der vorhergehenden Ansprüche,
**dadurch gekennzeichnet, daß**
jeder Quantisierer (12, 22) ein Eingangssignal durch Abschneiden niederwertiger Bits quantisiert.

5. Schaltungsanordnung nach einem der Ansprüche 1 bis 3,
**dadurch gekennzeichnet, daß**
jeder Quantisierer (12, 22) ein Eingangssignal durch Runden quantisiert.

6. Schaltungsanordnung nach einem der vorhergehenden Ansprüche,
**dadurch gekennzeichnet, daß**
jeder digitale Regelkreis (1, 2) einen dem Quantisierer (12, 22) vorgeschalteten Begrenzer (11, 21), eine Filterstruktur (13 - 16, 23) zur Filterung.des Quantisierungsfehlersignals (71, 72) und einen Addierer (10, 20), der ein Eingangssignal mit dem gefilterten Quantisierungsfehlersignal addiert, aufweist.

7. Schaltungsanordnung nach einem der vorhergehenden Ansprüche,
**dadurch gekennzeichnet, daß**
jeder digitale Regelkreis (1, 2) höchstens zweiter Ordnung ist, um Stabilitätsprobleme zu vermeiden.

## Claims

1. Circuit arrangement for quantizing digital signals and filtering the quantization noise, the circuit arrangement having a multiplicity of digital control loops (1, 2) with respective quantizers (12, 22), and a first control loop (1) being fed the digital signals which have a first word length of m bits, the quantization error signal (71, 72) of each quantizer (12, 22) being fed back in the respective digital control loop (1, 2) and filtered in the feedback path, and the quantization error signal (71) of the quantizer (12) of the first digital control loop (1) being fed to a second digital control loop (2), **characterized in that**
- the quantized output signal (8) of the first digital control loop (1) is adapted to a third word length of u bits, which is smaller than the first word length; and
- the quantized output signals (9) of the second digital control loop (2) are filtered by a digital filter (3) connected downstream of the second digital control loop (2) and are added in an adder (4) to the quantized output signal (8) of the first digital control loop (1) in order to delete the quantization errors, the output signal of said adder having a second word length of m bits and being the quantized output signal of the circuit arrangement.

2. Circuit arrangement according to Claim 1, **characterized in that** each digital filter (3) has a high-pass filter.

3. Circuit arrangement according to one of the preceding claims, **characterized in that** each digital filter (3) has two series-connected differentiators of first order (30-33).

4. Circuit arrangement according to one of the preceding claims, **characterized in that** each quantizer (12, 22) quantizes an input signal by cutting off low-order bits.

5. Circuit arrangement according to one of Claims 1 to 3, **characterized in that** each quantizer (12, 22) quantizes an input signal by rounding.

6. Circuit arrangement according to one of the preceding claims, **characterized in that** each digital control loop (1, 2) has a limiter (11, 21) upstream of the quantizer (12, 22), a filter structure (13-16, 23) for filtering the quantization error signal (71, 72), and an adder (10, 20) which adds an input signal to the filtered quantization error signal.

7. Circuit arrangement according to one of the preceding claims, **characterized in that** each digital control loop (1, 2) is at most of second order, in order to avoid stability problems.

## Revendications

1. Circuit pour la quantification de signaux numériques et pour filtrer le bruit de quantification, dans lequel le circuit présente une pluralité de circuits de régulation numériques (1, 2) avec des quantificateurs respectifs (12, 22) et on achemine à un premier circuit de régulation (1) les signaux numériques qui présentent une première largeur de mot de m bits, dans lequel le signal d'erreur de quantification (71, 72) de chaque quantificateur (12, 22) est réinjecté dans le circuit de régulation numérique respectif (1, 2) et filtré dans le bus de réinjection, et dans lequel le signal d'erreur de quantification (71) du quantificateur (12) du premier circuit de régulation numérique (1) est acheminé à un deuxième circuit de régulation numérique (2), **caractérisé en ce que** :
- le signal de sortie quantifié (8) du premier circuit de régulation numérique (1) est ajusté à une troisième largeur de mot de u bits, qui est plus petite que la première largeur de mot;
- les signaux de sortie quantifiés (9) du deuxième circuit de régulation numérique (2) sont filtrés par un filtre numérique (3) connecté en aval du deuxième circuit de régulation numérique (2) et sont ajoutés au premier signal de sortie quantifié (8) du premier circuit de régulation numérique (1) pour effacer l'erreur de quantification dans un additionneur (4), dont le signal de sortie présente une deuxième largeur de mot de m bits et qui est le signal de sortie quantifié du circuit.

2. Circuit selon la revendication 1, **caractérisé en ce que** chaque filtre numérique (3) présente un filtre passe-haut.

3. Circuit selon l'une quelconque des revendications précédentes, **caractérisé en ce que** chaque filtre numérique (3) présente deux différentiateurs du premier ordre (30-33) connectés en série.

4. Circuit selon l'une quelconque des revendications précédentes, **caractérisé en ce que** chaque quantificateur (12, 22) quantifie un signal d'entrée par troncature des bits d'ordre inférieurs.

5. Circuit selon l'une quelconque des revendications 1 à 3, **caractérisé en ce que** chaque quantificateur (12, 22) quantifie un signal d'entrée par arrondi.

6. Circuit selon l'une quelconque des revendications précédentes, **caractérisé en ce que** chaque circuit de régulation numérique (1, 2) présente un limiteur (11, 21) monté en amont du quantificateur (12, 22), une structure de filtrage (13 - 16, 23) pour filtrer le signal d'erreur de quantification (71, 72) et un additionneur (10, 20), qui ajoute un signal d'entrée au signal d'erreur de quantification filtré.

7. Circuit selon l'une quelconque des revendications précédentes, **caractérisé en ce que** chaque circuit de régulation numérique (1, 2) est au maximum du deuxième ordre pour éviter des problèmes de stabilité.
